Europäisches Patentamt

European Patent Office

Office européen des brevets

(19)

(11) Numéro de publication: **0 299 570**
**A1**

## DEMANDE DE BREVET EUROPEEN

(21) Numéro de dépôt: 88201420.2

(22) Date de dépôt: 07.07.88

(51) Int. Cl.4 **C30B 15/36 , C30B 33/00**

(30) Priorité: 09.07.87 FR 8709736

(43) Date de publication de la demande:
18.01.89 Bulletin 89/03

(84) Etats contractants désignés:
**DE FR GB IT NL**

(71) Demandeur: **Laboratoires d'Electronique et de Physique Appliquée L.E.P.
3, Avenue Descartes
F-94450 Limeil-Brévannes(FR)**

(84) **FR**

(71) Demandeur: **N.V. Philips'
Gloeilampenfabrieken
Groenewoudseweg 1
NL-5621 BA Eindhoven(NL)**

(84) **DE GB IT NL**

(72) Inventeur: **Schiller, Claude
Société Civile S.P.I.D. 209 rue de l'Université
F-75007 Paris(FR)**
Inventeur: **Farges, Jean-Pierre
Société Civile S.P.I.D. 209 rue de l'Université
F-75007 Paris(FR)**

(74) Mandataire: **Landousy, Christian et al
Société Civile S.P.I.D. 209, Rue de
l'Université
F-75007 Paris(FR)**

(54) **Procédé de réalisation de plaquettes-substrats orientées, à partir de lingots massifs semi-conducteurs du groupe III-V.**

(57) L'invention concerne un procédé de réalisation pour obtenir des plaquettes-substrats préparées pour recevoir des dispositifs semiconducteurs intégrés en matériaux du groupe III-V obtenu par tirage Czochralski. Ces matériaux présentant des propriétés anisotropes dont dépendent les performances des dispositifs semiconducteurs, il est de la plus haute importance de différencier les axes cristallographiques de chaque plaquette avec une précision meilleure que le demi-degré. Selon l'invention cette différenciation est faite en deux étapes. La première étape consiste en la différenciation des axes dès la formation du germe de tirage. A cet effet le germe de tirage est un parallélépipède rectangle (50) dont une arête présente une facette servant d'encoche de fixation du germe durant le tirage. Cette facette (010)(110) est repérée par rapport aux axes caractéristiques du lingot obtenu par tirage et permet de conserver cette information jusqu'à la concrétisation de ladite information par la taille de deux méplats sur le lingot massif lui-même. Le germe de tirage ainsi repéré étant utilisé un grand nombre de fois, la méthode selon l'invention permet un gain de temps considérable lors de l'élaboration industrielle des substrats.

FIG.5a

FIG.5b

## Procédé de réalisation de plaquettes-substrats orientées, à partir de lingots massifs semiconducteurs du group III-V

L'invention concerne un procédé de réalisation de plaquettes-substrats orientées, préparées pour recevoir des dispositifs semiconducteurs intégrés, à partir de lingots massifs de matériau semiconducteur du groupe III-V, ce procédé incluant au moins les étapes de :

a) formation d'un germe de tirage monocristallin en ce matériau du groupe III-V, présentant un axe de symétrie parallèle à un axe cristallographique $\overrightarrow{OZ}$ ;

b) tirage parallèlement à cet axe cristallographique $\overrightarrow{OZ}$ et par la méthode Czochralski, d'un lingot monocris tallin à partir de ce germe de tirage ;

c) façonnage du lingot massif pour lui donner la forme d'un cylindre d'axe confondu avec l'axe de tirage ;

d) détermination avec une précision meilleure que le degré, par une méthode mettant en oeuvre la diffraction des rayons X, de la direction de deux axes cristallographiques $\overrightarrow{OU}$ et $\overrightarrow{OV}$ orientés, caractéristiques de la section droite du cylindre, ces axes formant avec l'axe de tirage $\overrightarrow{OZ}$ un repère orthonormé ( $\overrightarrow{OU}$ , $\overrightarrow{OV}$ , $\overrightarrow{OZ}$ ) ;

e) façonnage sur le corps du cylindre parallèlement à l'axe $\overrightarrow{OZ}$ d'un grand méplat perpendiculaire à l'axe $\overrightarrow{OU}$ et d'un petit méplat perpendiculaire à l'axe $\overrightarrow{OV}$ ;

f) formation de plaquettes-substrats par tronçonnage du lingot massif, l'information de la différenciation des axes cristallographiques $\overrightarrow{OU}$ et $\overrightarrow{OV}$ étant conservée du fait de la formation sur les plaquettes-substrats, lors du tronçonnage, d'un grand et d'un petit pan coupé, résultant du grand et du petit méplat respectivement.

L'invention trouve son application dans l'industrialisation du procédé de réalisation des plaquettes substrats pour circuits intégrés et autres dispositifs électroniques ou électro-optiques en nouveaux matériaux semiconducteurs, et notamment des matériaux semiconducteurs du groupe III-V tels que le phosphure d'indium (InP).

Comme il est connu des demandes de brevets européens N° 0 191 530 et N° 87 200 403.1, pour obtenir une plaquette-substrat à partir d'un matériau massif semiconducteur monocristallin notamment du groupe III-V, ce matériau massif doit être réalisé par tirage Czochralski à partir d'un germe dont l'axe est orienté selon l'axe cristallographique [0 0 1], puis le lingot obtenu est débité en lamelles dont les plans et axes cristallographiques doivent être connus avec une précision meilleure que le demi-degré. En effet de la publication de HC Gatos et M.C. Lavine, dans J. Electrochem-Soc.107 (1960) p.427, il est connu que ces matériaux semiconducteurs présentent des propriétés anisotropes, et que de l'orientation du substrat et des éléments sur le substrat dépendent les performances des circuits électroniques ou électro-optiques ultérieurement réalisés sur ces substrats.

Des demandes de brevets précédemment citées, il est connu d'utiliser comme méthode de repérage des orientations des plans et axes cristallographiques du lingot massif de matériau semiconducteur, ainsi que des plaquettes-substrats qui en sont tirées, la méthode de Laüe par diffraction de rayons X. Cette méthode permet de déduire les orientations des éléments du réseau cristallographique et notamment des axes [110] et [1 $\overline{1}$ 0] à partir de photographies des taches de diffraction caractéristiques et de la mesure très précise des distances entre taches. Le repérage des axes est alors fait sous la forme de méplats perpendiculaires à ces axes et parallèle à l'axe de tirage, pratiqués sur le lingot massif. Lors de la découpe des lamelles, ces méplats forment des pans coupés qui permettent de ne pas recommencer le repérage des axes, plaquettes après plaquettes.

Cependant, jusqu'à présent dans de nombreux cas, la seule méthode de Laüe ne permet pas la différenciation entre l'axe [110] et l'axe [1 $\overline{1}$ 0]. Or il est de la plus haute importance, vue l'anisotropie des propriétés de certains semiconducteurs et notamment des semiconducteurs du groupe III-V, de ne pas confondre ces axes. Il est donc nécessaire de les différencier.

Cette différenciation est faite à ce jour par deux méthodes. La première méthode est connue de la demande de brevet européen N.87 200 403.1 et s'applique exclusivement aux cristaux tels que l'arséniure de gallium qui présentent relativement à l'axe [110] une tache de diffraction caractéristique d'intensité très différente de la tache de diffraction caractéristique relative à l'axe [1 $\overline{1}$ 0]. Cette première méthode consiste donc à appliquer la méthode de Laüe à chacun des méplats façonnés perpendiculairement aux axes [110] et [1 $\overline{1}$ 0], à différencier ces axes par leurs taches de diffraction et à former par exemple le méplat perpendiculaire à l'axe [110] d'une surface plus grande que celle du méplat perpendiculaire à l'axe [1 $\overline{1}$ 0] afin de conserver cette information par un pan coupé plus grand après découpe des plaquettes. A ce sujet on lira avec profit "La Revue Annuelle LEP 1981, p.55-56", éditée par "Service Information des Laboratoires d'Electronique et de Physique appliquée, 3 Avenue Descartes 94450 Limeil-Brevannes, FRANCE".

Cependant cette méthode n'est pas applicable à certains matériaux semiconducteurs tels que le phosphure d'indium qui présentent des taches de diffraction relatives aux axes [011] et [0 $\overline{1}$ 1] pratiquement d'égale intensité.

Il est donc connu, comme applicable à tout matériau semiconducteur et notamment au phosphure d'indium, de différencier l'axe [110] de l'axe [1 $\overline{1}$ 0] par gravure anisotrope d'une face (001) soit du lingot massif, soit d'une plaquette déjà découpée. A cet effet, une face (001) est préparée soit sur le lingot, soit sur une plaquette, et un système de masques est réalisé sous forme de rubans parallèles aux axes [110] et [1 $\overline{1}$ 0], ceux-ci n'étant pas différenciés. Par gravure chimique, apparaissent des configurations en queue d'aronde ou en Vé, suivant l'une ou l'autre direction, permettant de différencier l'axe [110] de l'axe [1 $\overline{1}$ 0]. Cette méthode est décrite dans Journal of Crystal Growth 58 (1982) 409-416.

Mais ces deux méthodes présentent des inconvénients. Le premier procédé est rapide et n'allonge pas le processus industriel, du fait que tous les résultats apparaissent en même temps par la méthode de Laüe. Ainsi le repérage et la différenciation des axes sont obtenus par la même opération. Cependant ce procédé n'est pas généralisable à tous les types de cristaux. Le second procédé est utilisable pour tous types de cristaux mais vient allonger le temps consacré à l'élaboration industrielle des monocristaux ou des plaquettes du fait que le repérage et la différenciation des axes [110] et [1 $\overline{1}$ 0] sont faits par deux opérations successives.

La présente invention propose un procédé tel que décrit dans le préambule qui permet de différencier les axes [110] et [1 $\overline{1}$ 0] caractéristiques de la section droite du lingot massif monocristallin, pour tous les types de cristaux, tout en diminuant le temps consacré au processus industriel.

Selon l'invention ce but est atteint au moyen d'un procédé tel que décrit dans le préambule, caractérisé en ce que la différenciation entre les axes cristallographiques caractéristiques de la section droite du cylindre est réalisée lors de l'étape de formation du germe de tirage et en ce qu'une marque de cette différenciation est appliquée à ce germe, pour conserver l'information de la différenciation jusqu'à l'étape de formation du grand et du petit méplat sur le cylindre, lesquels constituent un marquage approprié à conserver cette information jusqu'à l'étape de formation des plaquettes-substrats.

Ainsi, le même germe de tirage étant utilisé un grand nombre de fois pour le tirage d'un grand nombre de lingots, le procédé de réalisation conforme à l'invention permet de simplifier grandement le processus industriel d'obtention des plaquettes-substrats, en diminuant considérablement le nombre d'opérations relatives à l'identification des axes caractéristiques des surfaces des plaquettes.

L'invention sera mieux comprise au moyen de la description suivante illustrée par les figures annexées dont :

- la figure 1a qui représente un lingot de matériau semiconducteur encore muni de son germe de tirage ;

- la figure 1b qui représente ce même lingot doté de méplats de repérage ;

- la figure 2 qui représente un lingot de phosphure d'indium (InP) ainsi que ses axes et facettes de repérage ;

- la figure 3a qui représente une plaquette découpée dans le lingot massif de phosphure d'indium (InP) ;

- la figure 3b qui représente une plaquette de test préparée pour l'identification des axes caractéristiques du matériau, à partir de la plaquette de la figure 3a ;

- les figures 4a à 4d qui illustrent les étapes du procédé conduisant à l'identification des axes d'une plaquette de test ;

- les figures 5a et 5b qui montrent les deux possibilités de réalisation des germes de tirage, selon l'invention.

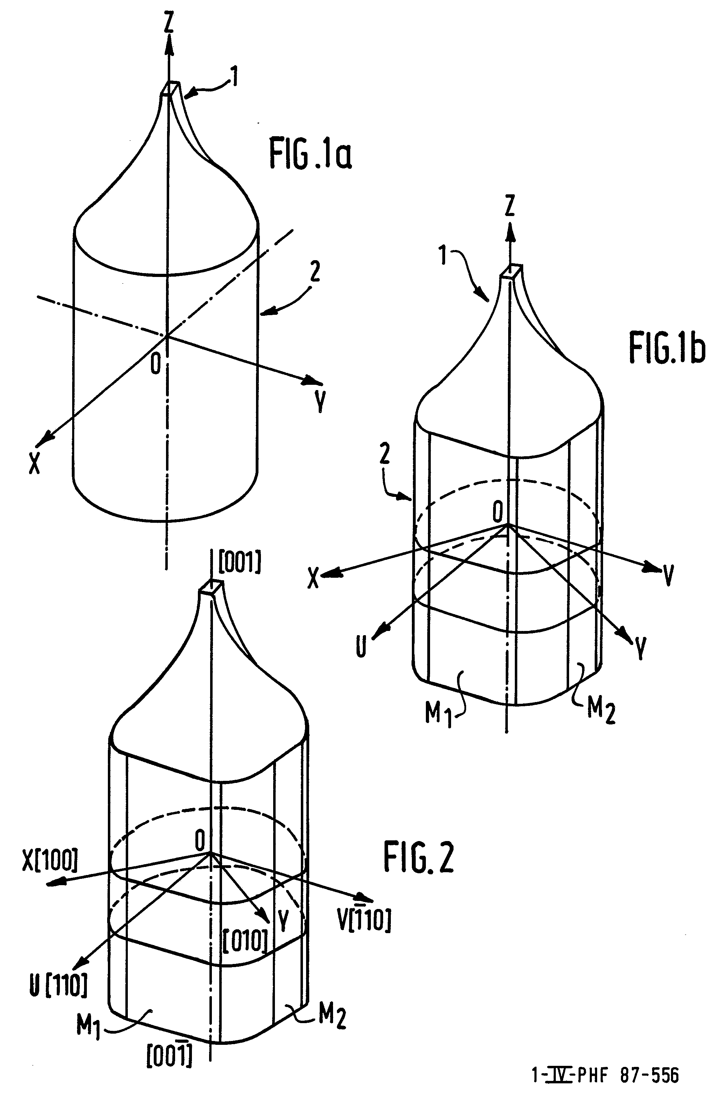

La figure 1a représente un lingot massif de matériau semiconducteur monocristallin, issu du tirage par la méthode Czochralski, connue par exemple de la publication ACTA ELECTRONICA Vol.13, Janvier 1970, N° 1 p.17-21. Voir également "La Revue Annuelle LEP 1979" p.7-8, Editée par "Service Information des Laboratoires d'Electronique et de Physique Appliquée, 3 Avenue Descartes, 94450 Limeil-Brevannes FRANCE. Ce lingot comprend un germe de tirage 1 et un corps de lingot 2.

Le corps du lingot présente une forme à peu près cylindrique, l'axe du cylindre coïncidant avec l'axe du tirage. Cet axe est choisi parallèle à un axe $\overrightarrow{OZ}$ du réseau cristallographique, le point Z étant pris du côté du germe et le point O du côté du bain de tirage.

Le corps du lingot est en outre orienté par rapport à deux autres axes cristallographiques $\overrightarrow{OX}$ et $\overrightarrow{OY}$ choisis pour former avec $\overrightarrow{OZ}$ un trièdre trirectangle orienté dans le sens trigonométrique direct. On détermine en outre deux axes $\overrightarrow{OU}$ et $\overrightarrow{OV}$ situés dans le plan $\overrightarrow{OX}$, $\overrightarrow{OY}$ et qui constituent des directions cristallographiques privilégiées pour la réalisation des circuits intégrés. Ces axes sont choisis du fait des propriétés particulières, liées à l'anisotropie que montre le cristal dans ces directions. Le système ( $\overrightarrow{OU}$ , $\overrightarrow{OV}$ , $\overrightarrow{OZ}$ ) forme un trièdre trirectangle direct.

Afin de conserver l'information de l'orientation du lingot par rapport aux axes $\overrightarrow{OU}$ et $\overrightarrow{OV}$, des méplats sont formés sur le corps du cylindre parallèlement à l'axe de tirage $\overrightarrow{OZ}$ : un premier méplat M₁ perpendiculaire à l'axe $\overrightarrow{OU}$ et formé du côté du point U ; et un second méplat M₂ perpendiculaire à l'axe $\overrightarrow{OV}$ et formé du côté du point V.

Dans le but de conserver l'information qui permet de différencier l'axe $\overrightarrow{OU}$ de l'axe $\overrightarrow{OV}$, l'un des méplats, ici M₁ est prévu de plus grande surface que le second, ici M₂. Le lingot ainsi orienté et muni de repères est représenté sur la figure 1b.

Lors de l'élaboration des circuits intégrés, les plaquettes-substrats sont obtenues par tronçonnage du lingot selon une direction perpendiculaire, ou proche de la perpendiculaire à l'axe $\overrightarrow{OZ}$. La connaissance de la position des axes $\overrightarrow{OU}$ et $\overrightarrow{OV}$ par rapport au plan de surface des plaquettes-substrats doit être très précise. En effet, les matériaux semiconducteurs montrent des propriétés fortement anisotropes et les performances, notamment des éléments actifs réalisés à leur surface, sont extrêmement différentes selon que ces éléments sont réalisés parallèlement à un axe ou à un autre.

Comme il a été dit précédemment, jusqu'à ce jour, la détermination des directions des axes cristallographiques $\overrightarrow{OU}$ et $\overrightarrow{OV}$ était faite par diffraction des rayons X, soit directement sur le lingot, soit sur les plaquettes-substrats avant toute utilisation. Dans ce premier temps les méplats M₁ et M₂ étaient formés égaux. Puis la différenciation de ces axes était faite par la mise en évidence de figures d'attaque chimique caractéristiques de chacune de ces directions et dans ce deuxième temps, l'un des méplats, par exemple M₁ était agrandi.

La figure 2 montre un lingot massif d'un matériau semiconducteur du groupe III-V, tel qu'issu du tirage. Ce matériau sera par exemple l'arséniure de gallium (GaAs) ou bien le phosphure d'indium (InP). Pour la réalisation de circuits intégrés de hautes performances, ces lingots sont de préférence tirés selon l'axe [001] et les plaquettes-substrats sont repérées par rapport aux axes [110] et [$\overline{1}$10]. Le méplat M₁ est choisi par exemple perpendiculaire à l'axe [110] donc parallèle au plan (110), alors que le méplat M₂ est choisi perpendiculaire à l'axe [$\overline{1}$10] donc parallèle au plan (110).

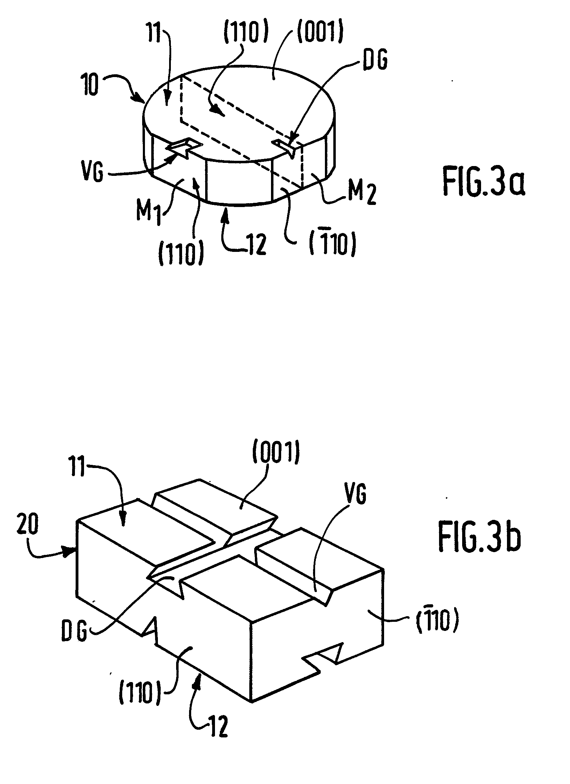

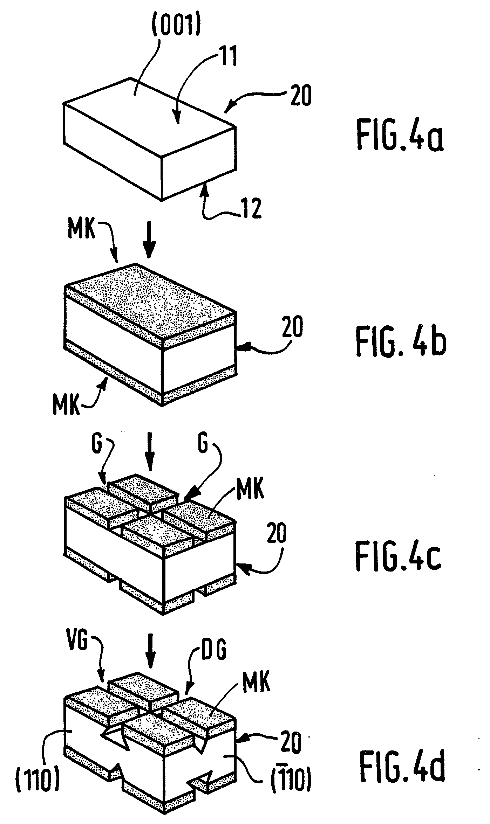

Les figures 3 et 4 illustrent la mise en oeuvre du procédé de différenciation des axes $\overrightarrow{OU}$ et $\overrightarrow{OV}$ au moyen de figures d'attaque chimique, tel que connu de l'état de la technique, et appliqué à l'arséniure de gallium (GaAs) ou bien au phosphure d'indium (InP). Les axes $\overrightarrow{OZ}$, $\overrightarrow{OU}$ et $\overrightarrow{OV}$ sont ici respectivement [001], [110] et [$\overline{1}$10].

La figure 3a montre une plaquette 10 tronçonnée dans le lingot 2 perpendiculairement à l'axe de tirage, et la figure 4a montre une plaquette rectangulaire 20 taillée dans la plaquette 10. La plaquette 20 présente une face 11 parallèle au plan (001) et une face opposée 12 parallèle au plan (001). Selon le procédé connu de différenciation des axes, une couche de laque photosensible servant de masque MK est appliquée respectivement sur la face 11 et la face 12 de la plaquette 20, comme montré sur la figure 4b. Puis des sillons G sont formés par développement de la laque, parallèlement aux axes [110] et [$\overline{1}$10] sur la face 11 et sur la face 12, les directions de ces axes ayant été précédemment déterminées par diffraction de rayons X. Cette étape est illustrée par la figure 4c. Enfin la plaquette 20 ainsi préparée est soumise à une gravure chimique qui fait apparaître dans l'ouverture des sillons G, des sillons gravés dans le matériau semiconducteur, comme montré sur la figure 4d, et sur la figure 3b après élimination des masques MK. Il est ainsi connu de l'état de la technique que les sillons de la face 11 (001) qui sont parallèles à l'axe [$\overline{1}$10] sont en forme de V, alors que ceux qui sont parallèles à l'axe [110] sont en forme de queue d'aronde. Ces sillons sont respectivement notés DG et VG sur les figures 3 et 4. D'autre part, ce résultat est inversé sur la face 12 {00$\overline{1}$}.

Ainsi, selon cette méthode connue, les axes [110] et [$\overline{1}$10] peuvent être différenciés. Afin de conserver l'information obtenue, le méplat M₁ est ensuite agrandi. Cette méthode connue de différenciation est longue et compliquée. D'une façon plus simple et comme montré figure 3a, il peut être réservé sur la plaquette 10 deux petites zones dans les directions des axes à différencier, le reste des surfaces de la plaquette étant masqué, et l'attaque chimique peut être pratiquée dans ces petites zones. Il apparaît alors des figures caractéristiques en Vé (VG) ou en queue d'aronde (DV) permettant de différencier les axes. Cette méthode est en fait pratiquement aussi longue que la précédente du fait qu'elle en comporte toutes les étapes sauf la découpe de la plaquette 20.

La présente invention propose une méthode qui permet de s'affranchir de cette complexité.

Selon l'invention la différenciation des axes $\overrightarrow{OU}$ et $\overrightarrow{OV}$ est faite dès la formation du germe de tirage.

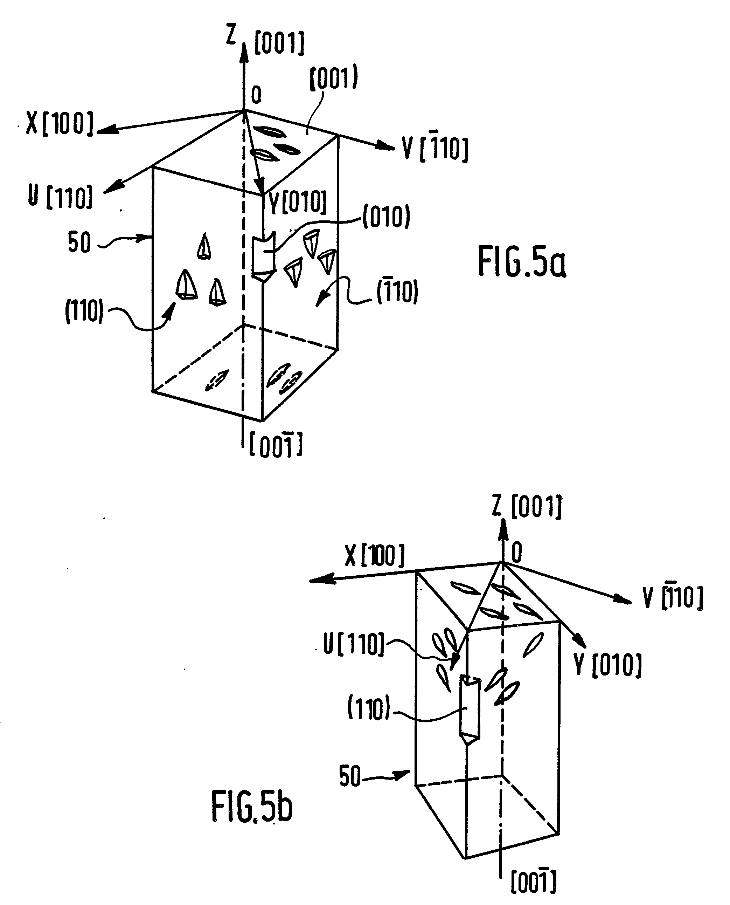

Tel que montré sur les figures 5, le germe de tirage est réalisé sous la forme d'un prisme à base carrée, d'axe parallèle à l'axe de tirage $\overrightarrow{OZ}$. Il existe alors deux positions avantageuses possibles pour les faces latérales du prisme.

La figure 5a montre la première position avantageuse possible selon laquelle les faces latérales sont deux à deux parallèles aux axes $\overrightarrow{OU}$ et

$\overrightarrow{OV}$ respectivement. Ainsi dans l'exemple choisi de l'arséniure de gallium (GaAs) et du phosphure d'indium (InP) les faces latérales sont parallèles aux axes [110] et [$\overline{1}$10] respectivement. c'est-à-dire sont des plans (110) et ($\overline{1}$10) respectivement, l'axe du prisme étant l'axe [001].

La figure 5b montre la seconde position avantageuse possible selon laquelle les faces latérales du prisme sont à 45° des axes $\overrightarrow{OU}$ et $\overrightarrow{OV}$ respectivement. Ces axes se trouvent donc dans les plans diagonaux du dièdre formé par les faces.

Dans l'exemple choisi de l'arséniure de gallium (GaAs) et du phosphure d'indium (InP) où les axes $\overrightarrow{OU}$ . $\overrightarrow{OV}$ sont à 45° des axes $\overrightarrow{OX}$ , $\overrightarrow{OY}$ , les faces du prisme sont donc parallèles aux axes $\overrightarrow{OX}$ . $\overrightarrow{OY}$ . Ainsi, les axes [110] et [$\overline{1}$10] sont dans les plans diagonaux, et les faces sont donc parallèles aux axes [110] et [010], l'axe du prisme étant parallèle à l'axe [001]. Les faces latérales du prisme sont des plans (010) et (100) respectivement.

Au moyen de ces germes de tirage, les lingots monocristallins massifs obtenus ont pour axe de symétrie du cylindre l'axe $\overrightarrow{OZ}$ [001] comme il a été dit. Dans les conditions de tirage par la méthode Czochralski, si les axes $\overrightarrow{OU}$ et $\overrightarrow{OV}$ sont repérés et différenciés de manière visible et permanente sur le germe de tirage, la direction de ces axes se maintient constante dans le lingot et par conséquent cette information reste valable en tout point du lingot.

L'orientation des faces latérales du germe, par rapport aux axes $\overrightarrow{OU}$ et $\overrightarrow{OV}$ est faite de façon très précise par la méthode connue de diffraction des rayons X.

La différenciation des axes $\overrightarrow{OU}$ et $\overrightarrow{OV}$ du lingot massif est donc faite selon l'invention par la différenciation des plans qui forment les faces latérales du prisme à base carrée constituant le germe de tirage.

A cet effet, le germe déjà façonné en prisme à base carrée dont les faces latérales sont soit parallèles soit à 45° des axes $\overrightarrow{OU}$ et $\overrightarrow{OV}$ , mais non encore différenciées, est plongé dans un bain d'attaque chimique, sans aucun masquage.

Ce bain sera avantageusement constitué des proportions :

- pour l'arséniure de gallium : 5 volumes d'acide sulfurique ($H_2SO_4$), 1 volume d'eau oxygénée ($H_2O_2$) un volume d'eau ($H_2O$) à la température du mélange c'est-à-dire environ 60° pendant 2 mn ;

- pour le phosphure d'indium (InP) : 1 volume d'acide sulfurique ($H_2SO_4$), 1 volume d'eau oxygénée ($H_2O_2$), un volume d'eau ($H_2O$) à la température du mélange c'est-à-dire environ 60° pendant 2 mn.

Il apparaît alors sur les faces du germe de tirage des figures d'attaque chimique très fines, mais néanmoins suffisantes à leur différenciation. Ces figures d'attaques chimiques sont représentées respectivement sur les germes de tirage illustrés par les figure 5a et 5b.

Sur la figure 5a, il est recherché dans le cas de l'arséniure de gallium et du phosphure d'indium, de différencier les faces parallèles à $\overrightarrow{OU}$ ou à $\overrightarrow{OV}$ . Comme il est montré sur cette figure, l'axe $\overrightarrow{OZ}$ sera placé en position verticale et dirigé vers le haut, et le repère ( $\overrightarrow{OU}$ . $\overrightarrow{OV}$ , $\overrightarrow{OZ}$ ) sera orienté dans le sens direct, si l'on considère que les figures d'attaque sur la face carrée (001) supérieure sont de forme oblongue et parallèle à $\overrightarrow{OV}$ [$\overline{1}$10], les figures d'attaque sur la face carrée (00$\overline{1}$) inférieure sont de forme oblongue et parallèle à $\overrightarrow{OU}$ [110]. Les faces latérales parallèles à l'axe $\overrightarrow{OU}$ qui dans l'exemple choisi ici sont des plans ($\overline{1}$10) et (1$\overline{1}$0) montrent des figures d'attaque en forme de pointes de flèche dirigées vers le bas. Par contre les faces latérales parallèles à l'axe $\overrightarrow{OV}$ , qui dans cet exemple sont des plans (110) et ($\overline{11}$0) montrent des figures d'attaque en forme de pointes de flèche dirigée vers le point 2.

Or il est nécessaire pour rendre le germe de tirage apte à remplir sa fonction de le munir d'une encoche pour pouvoir le fixer sur le bâti de tirage Czochralski.

Cette encoche servira de repérage définitif et permanent des axes $\overrightarrow{OU}$ et $\overrightarrow{OV}$ . Dans l'exemple représenté sur la figure 5a, elle sera réalisée sur l'arête située dans le plan diagonal de l'angle formé par ( $\overrightarrow{OU}$ , $\overrightarrow{OV}$ ). Elle constituera donc une facette (010) et est perpendiculaire à l'axe $\overrightarrow{OY}$ .

Ainsi, l'information de la différenciation des axes $\overrightarrow{OU}$ et $\overrightarrow{OV}$ est conservée tout au long du procédé de réalisation des plaquettes-substrats sans qu'il soit nécessaire de procéder à de nouvelles opérations pour redifférencier ces axes.

De plus, le même germe de tirage étant utilisé un grand nombre de fois, le gain de temps se multiplie par le nombre d'utilisations.

Sur la figure 5b, il est recherché, dans le cas de l'arséniure de gallium et du phosphure d'indium de différencier les faces à 45° de $\overrightarrow{OU}$ et $\overrightarrow{OV}$ , c'est-à-dire les faces parallèles à $\overrightarrow{OX}$ et $\overrightarrow{OY}$ . Comme il est montré sur cette figure, l'axe $\overrightarrow{OZ}$ sera placé en position verticale et dirigé vers le haut, et le repère ( $\overrightarrow{OX}$ , $\overrightarrow{OY}$ , $\overrightarrow{OZ}$ ) sera orienté dans le sens direct, si l'on considère que les figures d'attaque sur la face carrée supérieure (001) sont de forme oblongue et parallèles à l'axe $\overrightarrow{OV}$ , alors que les figures d'attaque sur la la face carrée inférieure (00$\overline{1}$) sont de forme oblongue et parallèles à l'axe $\overrightarrow{OU}$ . Les faces latérales du prisme qui dans le cas décrit ici sont des plans (100) et (010) portent des figures d'attaque oblongues inclinées à 45° par rapport au plan défini par les bases du prisme. Ces figures d'attaque permettent de repérer une arête du prisme située dans un plan diagonale contenant par exemple l'axe $\overrightarrow{OU}$. Une encoche servant à la fois à cette différenciation et à la fixation du germe dans le bâti de tirage sera alors réalisée, comme il a été dit précédemment. Dans cet exemple l'encoche sera une facette (110).

**Revendications**

1. Procédé de réalisation de plaquettes-substrats orientées, préparées pour recevoir des dispositifs semiconducteurs intégrés, à partir de lingots massifs de matériau semiconducteur du groupe III-V, ce procédé incluant au moins les étapes de :

a) formation d'un germe de tirage monocristallin en ce matériau du groupe III-V, présentant un axe de symétrie parallèle à un axe cristallographique $\overrightarrow{OZ}$ ;

b) tirage parallèlement à cet axe cristallographique $\overrightarrow{OZ}$ et par la méthode Czochralski, d'un lingot monocristallin à partir de ce germe de tirage ;

c) façonnage du lingot massif pour lui donner la forme d'un cylindre d'axe confondu avec l'axe de tirage ;

d) détermination avec une précision meilleure que le degré, par une méthode mettant en oeuvre la diffraction des rayons X, de la direction de deux axes cristallographiques $\overrightarrow{OU}$ et $\overrightarrow{OV}$ orientés, caractéristiques de la section droite du cylindre, ces axes formant avec l'axe de tirage $\overrightarrow{OZ}$ un repère orthonormé ( $\overrightarrow{OU}$ , $\overrightarrow{OV}$ , $\overrightarrow{OZ}$ ) ;

e) façonnage sur le corps du cylindre parallèlement à l'axe $\overrightarrow{OZ}$ d'un grand méplat perpendiculaire à l'axe $\overrightarrow{OU}$ et d'un petit méplat perpendiculaire à l'axe $\overrightarrow{OV}$ ;

f) formation de plaquettes-substrats par tronçonnage du lingot massif, l'information de la différenciation des axes cristallographiques $\overrightarrow{OU}$ et $\overrightarrow{OV}$ étant conservée du fait de la formation sur les plaquettes-substrats, lors du tronçonnage, d'un grand et d'un petit pan coupé, résultant du grand et du petit méplat respectivement, caractérisé en ce que la différenciation entre les deux axes cristallographiques $\overrightarrow{OU}$ et $\overrightarrow{OV}$ caractéristiques de la section droite du cylindre est réalisée lors de l'étape de formation du germe de tirage, et en ce qu'une marque de cette différenciation est appliquée à ce germe, pour conserver l'information jusqu'à l'étape de formation du grand et du petit méplat sur le cylindre.

2. Procédé de réalisation selon la revendication 1, caractérisé en ce que, lors de l'étape de formation du germe de tirage, ce dernier est façonné sous la forme d'un prisme à base carrée, l'axe du prisme étant parallèle à l'axe cristallographique $\overrightarrow{OZ}$ choisi pour le tirage, les faces latérales du prisme étant parallèles aux axes cristallographiques caractéristiques $\overrightarrow{OU}$ et $\overrightarrow{OV}$ respectivement, en ce que la différenciation entre ces axes cristallographiques caractéristiques $\overrightarrow{OU}$ et $\overrightarrow{OV}$ est réalisée par une méthode de gravure anisotrope appliquée aux faces du prisme, en ce que le marquage du germe de tirage qui permet de conserver cette information de la différenciation durant le tirage, consiste en une encoche pratiquée sous la forme d'une facette cassant l'arête du prisme située dans le plan bissecteur des deux axes cristallographiques caractéristiques orientés $\overrightarrow{OU}$ et, $\overrightarrow{OV}$ , et en ce que cette encoche sert en même temps d'encoche de fixation du germe dans le bâti de tirage pour mettre en oeuvre la méthode Czochralski, et en ce que le germe muni de l'encoche de marquage est conservé uni au lingot issu du tirage au moins jusqu'à l'étape de façonnage du grand et du petit méplat.

3. Procédé de réalisation selon la revendication 1, caractérisé en ce que, lors de l'étape de formation du germe de tirage, ce dernier est façonné sous la forme d'un prisme à base carrée, l'axe du prisme étant parallèle à l'axe cristallographique $\overrightarrow{OZ}$ choisi pour le tirage, les faces latérales du prisme étant telles que l'un des axes caractéristiques $\overrightarrow{OU}$ ou $\overrightarrow{OV}$ est dans leur plan bissecteur, en ce que la différenciation entre ces faces et donc entre les axes cristallographiques caractéristiques est réalisée par la méthode de gravure anisotrope appliquée aux faces du prisme, en ce que le marquage du germe de tirage qui permet de conserver cette information de la différenciation durant le tirage consiste en une encoche pratiquée sous forme d'une facette cassant l'arête du prisme située dans le plan bissecteur qui contient l'un des axes $\overrightarrow{OU}$ ou $\overrightarrow{OV}$ , en ce que cette encoche sert en même temps d'encoche de fixation du germe dans le bâti de tirage pour mettre en oeuvre la méthode Czochralski et en ce que le germe muni de l'encoche de marquage est conservé uni au lingot issu du tirage au moins jusqu'à l'étape de façonnage du grand et du petit méplat.

4. Procédé selon l'une des revendications 2 ou 3, caractérisé en ce que le matériau semiconducteur est l'arséniure de gallium (GaAs) et en ce que la méthode de gravure anisotrope pour la différenciation des axes $\overrightarrow{OU}$ et $\overrightarrow{OV}$ consiste en l'immersion du germe de tirage dans un bain composé de 5 volumes d'acide sulfurique, 1 volume d'eau oxygénée, 1 volume d'eau pendant 2 mn produisant sur les faces du germe de tirage de petites figures d'attaque caractéristiques de leur plan cristallographique.

5. Procédé selon l'une des revendications 2 ou 3 caractérisé en ce que le matériau semiconducteur est le phosphure d'indium (InP) et en ce que la méthode de gravure anisotrope pour la différenciation des axes $\overrightarrow{OU}$ et $\overrightarrow{OV}$ consiste en l'immersion du germe de tirage dans un bain composé de 1 volume d'acide sulfurique, 1 volume d'eau oxygénée, 1 volume d'eau pendant 2 mn produisant sur les faces du germe de tirage de petites figures d'attaque caractéristiques de leur plan cristallographique.

6. Procédé selon l'une des revendications précédentes, caractérisé en ce que l'axe de tirage $\overrightarrow{OZ}$ est l'axe [001], le plan de la section droite de cylindre étant alors le plan (001) du cristal.

7. Procédé selon la revendication 6, caractérisé en ce que les axes $\overrightarrow{OU}$ et $\overrightarrow{OV}$ caractéristiques choisis sont les axes [110] et [1 $\overline{1}$ 0] du cristal.

8. Procédé selon la revendication 7, caractérisé en ce que le grand méplat est formé perpendiculairement à l'axe [110] et le petit méplat perpendiculairement à l'axe [1 $\overline{1}$ 0] du cristal.

FIG.1a

FIG.1b

FIG.2

11 (110) (001)

10 DG

VG

M1 M2

(110) 12 (Ī10)

**FIG.3a**

11 (001)

20 VG

DG (Ī10)

(110)

12

**FIG.3b**

(001)

11

20

FIG.4a

12

MK

MK

20

FIG. 4b

G          G

MK

20

FIG.4c

VG          DG

MK

20

(110)        (Ī10)

FIG.4d

FIG.5a

FIG.5b

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | PATENT ABSTRACTS OF JAPAN, vol. 9, no. 306 (C-317)[2029], 3 décembre 1985; & JP-A-60 145 989 (MITSUBISHI MONSANTO KASEI K.K.) 01-08-1985 <br> * En entier * <br> --- | 1-3 | C 30 B   15/36 <br> C 30 B   33/00 |
| A | TECHNICAL DIGEST, WESTERN ELECTRIC, no. 66, avril 1982, pages 19-20, New York, US; D.W. HILL: "Fabrication of seed crystals" <br> --- | | |
| A | US-A-3 046 029  (WEBER) <br> --- | | |
| A | US-A-3 413 098  (DERMATIS) <br> ----- | | |

DOMAINES TECHNIQUES
RECHERCHES (Int. Cl.4)

C 30 B
G 01 N

Le présent rapport a été établi pour toutes les revendications

| Lieu de la recherche | Date d'achèvement de la recherche | Examinateur |
|---|---|---|
| LA HAYE | 29-09-1988 | COOK S.D. |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
                    
& : membre de la même famille, document correspondant